# EUROPEAN PATENT SPECIFICATION

(11) **EP 4 445 414 B1**
(45) Date of publication and mention of the grant of the patent: **11.02.2026**
(21) Application number: 23776884.1
(22) Date of filing: 21.09.2023
(51) Int. Cl.: H05K 3/40, H05K 1/11, H01L 23/498, H05K 3/46

(54) **COMPONENT CARRIER AND METHOD OF MANUFACTURING A COMPONENT CARRIER**
KOMPONENTENTRÄGER UND VERFAHREN ZUR HERSTELLUNG EINES KOMPONENTENTRÄGERS
SUPPORT DE COMPOSANT ET PROCÉDÉ DE FABRICATION D'UN SUPPORT DE COMPOSANT

(30) Priority: 02.03.2023 CN 202310194150
(43) Date of publication of application: 16.10.2024
(73) Proprietor: AT&S Austria Technologie & Systemtechnik Aktiengesellschaft, 8700 Leoben (AT)
(72) Inventor: LEE, Minwoo, Yubei, Chongqing, 401120 (CN)
(86) International application number: PCT/EP2023/076009
(87) International publication number: WO 2024/179700

(56) References cited:
- KR-A- 20230 015 627
- US-A1- 2020 253 050
- US-A1- 2020 253 053
- US-A1- 2020 253 062

## Description

### Field of the Invention

The invention relates to a component carrier, and to a method of manufacturing a component carrier.

### Technological Background

In the context of growing product functionalities of component carriers equipped with one or more components and increasing miniaturization of such components as well as a rising number of components to be connected to the component carriers such as printed circuit boards or component carriers, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

Conventional approaches of forming component carriers are still challenging.

US2020/253062A1, US2020/253053A1, US2020/253050A1 and KR20230015627A disclose component carriers and dimple filling processes.

### Summary of the Invention

It is an object of the invention to form a compact and reliable component carrier-type package.

This object is solved by the subject-matter according to the independent claims. Further embodiments are described by the dependent claims.

According to an exemplary embodiment of the invention, a component carrier is provided which comprises a carrier body having a hole filled partially with a metal structure delimited by an exterior dimple, an electrically conductive dimple filling at least partially filling the dimple, a dielectric layer structure on at least part of the carrier body and on part of the dimple filling, and a conductive element extending through the dielectric layer structure and being in contact with the dimple filling.

According to another exemplary embodiment of the invention, a method of manufacturing a component carrier is provided, wherein the method comprises providing a carrier body having a hole filled partially with a metal AD:jc structure delimited by an exterior dimple, at least partially filling the dimple by an electrically conductive dimple filling, forming a dielectric layer structure on at least part of the carrier body and on part of the dimple filling, and forming a conductive element extending through the dielectric layer structure and being in contact with the dimple filling.

In the context of the present application, the term "component carrier" may particularly denote any support structure which is capable of accommodating one or more components thereon and/or therein for providing mechanical support and/or electrical connectivity and/or thermal connectivity. In other words, a component carrier may be configured as a mechanical and/or electronic and/or thermal carrier for components. In particular, a component carrier may be one of a printed circuit board, an organic or inorganic interposer, and an IC (integrated circuit) substrate. A component carrier may also be a hybrid board combining different ones of the above mentioned and/or other types of component carriers.

In the context of the present application, the term "carrier body" may particularly denote a physical structure (for instance a plate-type structure) providing mechanical stability for carrying constituents of the component carrier. For instance, the carrier body may be a base structure being processed during a manufacturing process of the component carrier for forming constituents of the component carrier thereon and therein. The carrier body may comprise a core with the option of multiple layers (such as signal layers) comprising electrically insulating layers and electrically conductive layers or just a mechanical supporting body without electrical function. The carrier body can comprise inorganic material and/or organic material.

In the context of the present application, the term "hole of carrier body" may particularly denote an opening in the carrier body. Such a hole may be a through hole extending through the entire carrier body, may be a blind hole extending into the carrier body but having a closed bottom, or may be a groove, cavity (for instance for embedding a component) or recess of any shape. During executing a method of filling holes of a carrier body with an electrically conductive material according to an exemplary embodiment, it may be possible that at least 10 holes, in particular at least 100 holes of the carrier body are filled partially or entirely with electrically conductive material.

In the context of the present application, the term "metal structure" may particularly denote a solid metal filling part of a hole of a carrier body. Preferably, the metal structure is a plated metal structure which may be formed by plating. Plating a hole in a carrier body may comprise an electroless deposition or sputtering followed by electroplating (in particular galvanic plating). When a plurality of plating stages are carried out, interfaces between different plating portions of a plated metal structure may be identified based on a cross-sectional analysis of the plated metal structure. Towards an exterior of the plated hole, the plated metal structure may be delimited by a concave recess which may be denoted as dimple. A dimple may be present in particular when the aspect ratio of the hole (i.e. the ratio between length and minimum diameter of the hole filled with the plated metal structure) is high, for instance at least five. However, the metal structure may be formed also by another process than plating. For example, the metal structure may be formed by conductive paste filling, i.e. may be a metal paste structure. It is also possible that the metal structure is formed as a plated through hole filled by resin and being subjected to cap plating. Furthermore, it is possible to form the metal structure by electrolytic plating.

In the context of the present application, the term "exterior dimple" may particularly denote a recess delimited by a concave surface area of a metal structure in a hole of a carrier body and delimited by a plane corresponding to a main surface of the carrier body. When plating a hole in a carrier body with metal such as copper, an outermost portion of the hole may remain unfilled, in particular in case of a high aspect ratio. Such an outermost portion may be delimited by a concave surface of the metal structure. An empty volume of the hole next to said concave surface may be denoted as dimple.

In the context of the present application, the term "electrically conductive dimple filling" may particularly denote an additional filling medium filling at least part of the exterior dimple. Such a filling process may be for instance a further plating stage or another metal deposition or plugin process (such as printing or dispensing). The electrically conductive dimple filling may fill the dimple partially or preferably entirely. A person skilled in the art will understand that, by a cross-sectional analysis of the hole filling, the electrically conductive dimple filling may be distinguished from the metal structure.

In the context of the present application, the term "dielectric layer structure" may particularly denote a planar electrically insulating structure. For instance, such a layer structure may be a continuous layer, a patterned layer or a plurality of non-consecutive islands within a common plane. It may comprise organic and/or inorganic material.

In the context of the present application, the term "conductive element" may particularly denote a physical structure made of an electrically conductive and/or thermally conductive material and being configured for providing an electric and/or a thermal connection function in the component carrier. For example, the conductive element may be a metallic material (for example copper) or a non-metallic material (for instance graphite). In particular, the conductive element may be a solid material, such as a solid metallic material. For instance, the conductive element may be configured as a metallic via (in particular a tapering metallic via or a metallic laser via), a pillar, a bump, etc. The conductive element may have a tapering end section ending in a planar front surface. A tapering geometry may be advantageous for filling. However, a straight geometry of the conductive element may be possible as well (for instance when forming a hole by chemical mechanical drilling). In particular, a conductive element may extend vertically up to the carrier body. A plurality of conductive elements may extend up to different dimple fillings, for instance parallel to each other.

In the context of the present application, the term "in contact with" may particularly denote a face-to-face contact between two connected entities contacting each other without an additional intermediate material in between. Such a direct physical contact may also establish a direct physical connection between said connected entities. In particular, direct physical contact between a front surface of the conductive element and a planar exterior surface of the electrically conductive dimple filling may create a proper electric and/or thermal connection between the conductive element and the electrically conductive dimple filling at a vertical level corresponding to a main surface of the hole.

In the context of the present application, the term "main surface" of a body may particularly denote one of two largest opposing surfaces of the body or outermost opposing surfaces of the body. The main surfaces may be connected by circumferential side walls. The thickness of a body, such as the carrier body, may be defined by the distance between the two opposing main surfaces.

According to an exemplary embodiment of the invention, a component carrier is equipped with a carrier body having one or more holes extending therein. A metal structure may be inserted in the one or more holes to fill them partially, preferably by plating or alternatively by paste filling or metal post pinning. A portion of the hole being not filled with the metal structure may be delimited by an exterior dimple. The dimple volume may then be at least partially filled with an electrically conductive dimple filling. Advantageously, a conductive element may be connected with direct physical contact to said electrically conductive dimple filling, to thereby establish a reliable electric and/or thermal connection (for example a reliable copper-copper connection) between the conductive element and the conductive dimple filling, since a direct metal to metal (for example copper to copper) connection may be preferred to perform the electrical and thermal transmission. By the described manufacturing architecture, it may be possible to form in a simple and reliable way an electric and/or thermal connection to an electrically conductive dimple filling in a hole of a carrier body. Advantageously, such a connection can be created in a quick and easy way on an industrial scale, with a high yield and for very different applications.

### Detailed Description of Exemplary Embodiments

In the following, further exemplary embodiments of the component carrier and the method will be explained.

In an embodiment, the at least one hole is at least one through-hole extending through the entire carrier body. Forming one or more through holes in the carrier body and filling them with metal may allow to contact the (for example plated) metal at both opposing ends of the hole by two conductive elements. Hence, also a two-sided connection may be formed with low effort and high reliability.

In an embodiment, the carrier body is an inorganic carrier body, in particular comprising or consisting of glass, ceramic, or a semiconductor, for example silicon. In the context of the present application, the term "inorganic carrier body" may particularly denote a carrier structure which comprises inorganic material. In particular, dielectric material of the inorganic carrier body or even the entire inorganic carrier body may be made exclusively or at least substantially exclusively from inorganic material. In another embodiment, the inorganic carrier body may comprise inorganic dielectric material and additionally another dielectric material and/or other inorganic material. An inorganic compound may be a chemical compound that lacks carbon-hydrogen bonds or a chemical compound that is not an organic compound. In an example, the inorganic carrier body may comprise glass, for example silicon base glass, in particular soda lime glass, and/or boro-silicate glass and/or alumo-silicate glass and/or lithium silicate glass and/or alkaline free glass. In another example, the inorganic carrier body may comprise ceramic material, for example aluminum nitride and/or aluminum oxide and/or silicon nitride and/or boron nitride and/or tungsten comprising ceramic material. Yet, in another example, the inorganic carrier body may comprise semiconductive material, for example silicon and/or germanium and/or silicon oxide and/or germanium oxide and/or silicon carbide and/or gallium nitride. In a further embodiment, the inorganic carrier body may comprise elemental metal and/or metal alloys, for example, copper and/or tin and/or bronze. Yet in another embodiment, the inorganic carrier body may comprise inorganic material, which is not listed in the above mentioned examples, such as: MoS₂, CuGaO₂, AgAlO₂, LiGaTe₂, AgInSe₂, CuFeS₂, BeO.

Most preferred is a carrier body comprising glass or consisting of glass. Such a carrier body may comprise or consist of silicon dioxide. In particular, the glass carrier body may have glass as main constituent. For example, the glass carrier body may be block-, strip- or plate-shaped. The major material component (in particular the material component of the glass carrier body providing the highest weight percentage) of the glass carrier body is glass, in particular silicon-based glass. For instance, at least 90 weight percent of the glass carrier body may be glass. For example, the glass carrier body may consist only of glass. It is however also possible that the glass carrier body comprises one or more additional other materials. Advantageously, the glass carrier body may have very flat surfaces so that a planarization stage during processing may be dispensable and fine line processing above it may be fully supported. Furthermore, the glass carrier body may have a high degree of thermal stability so that thermally-caused undesired phenomena such as thermal stress, warpage, shrinkage and delamination will not impact the component carrier significantly. This can make the whole component carrier stable with controllable change of the dimension of the component carrier (such as shrinkage would be less). Furthermore, glass material may show a low DK and low DF behavior with good dielectric property and may therefore support low loss high-frequency (in particular improving radio frequency, RF) and highspeed applications as well as high performance computing application with good signal integrity and low loss.

In an embodiment, a surface roughness Ra of the carrier body, in particular when embodied as glass body, is not more than 100 nm, in particular not more than 50 nm. Such a low roughness Ra may ensure that a wiring structure may be formed above this surface of the glass carrier body with highest spatial accuracy. Thus, the described embodiment may be particularly appropriate for high density integration (HDI) applications and/or for fine line patterning.

In an embodiment, the carrier body is an organic carrier body, in particular comprising or consisting of a resin. In the context of the present application, the term "organic carrier body" may particularly denote a block-, strip- or plate-shaped structure which comprises a dielectric material having an organic compound. In particular, dielectric material of the organic carrier body may be made exclusively or at least substantially exclusively from organic material. In another embodiment, the organic carrier body may comprise organic dielectric material and/or additionally another dielectric material. An organic compound may be a chemical compound that contains carbon-hydrogen bonds. For example, the organic carrier body may comprise an organic resin material, an epoxy material, etc. For instance, the organic carrier body may be an organic integrated circuit (IC) substrate or a printed circuit board (PCB). In particular, integrated circuit substrates dielectrics may be dielectrics used for the organic integrated circuit substrate.

For instance, a thickness of the dielectric layer structure may be in a range from 5 µm to 20 µm, for example 10 µm. Such a small thickness may allow a fine line pattern on the dielectric layer structure to benefit from the high smoothness of the carrier body directly beneath the thin dielectric layer structure.

In an embodiment, at least two conductive elements are provided, each one extending with direct physical contact up to said dimple filling from a respective one of two opposing ends of the at least one hole extending through the entire carrier body. Hence, each of the two opposing and exposed end portions of the dimple filling next to the opposing main surfaces of the for instance plate-shaped carrier body may be contacted thermally and/or electrically by a respective conductive element abutting thereon (preferably without protruding therein). Thus, a symmetric contact structure may be formed on both sides of the carrier body which may limit warpage.

In an embodiment, a photoimageable dielectric (PID) can be used to form a pattern. Then, a copper pillar or bump may be formed to connect with the dimple filling of the through glass via (TGV), or another hole the carrier body.

In an embodiment, the dielectric layer structure is configured as a stress release layer. In the context of the present application, the term "stress release layer" may particularly denote a structure being configured for releasing stress from an interface between the carrier body (in particular a glass plate) and a further build-up (for instance an organic laminate) or an electronic component or the stress generated from the through hole (like TGV) formation of the carrier body. Such a stress may be created when connecting constituents with very different coefficients of thermal expansion (CTE) during production under cold and/or hot condition. Without wishing to be bound to a specific theory, it is presently believed that the stress creation process works as follows: Cracks may propagate under tensile stress. Resin can bring the compression stress at a crack on glass. The glass CTE may be very low (such as about 3 ppm/K), and the Young modulus of glass is very high. In contrast to this, the CTE of copper may be about 17 ppm/K. The CTE of resin may be higher or lower than that of copper. The Young modulus of resin may be relatively low. By adopting the interface of copper, if the copper trace (thin and narrower) is on glass directly, stress on the trace at the interface should be high. If the pattern on the dielectric layer is bonded to glass directly, the gap between the glass and the copper is larger. In particular by adjusting material properties, such as the CTE value and/or the value of the Young modulus, of the stress release layer, stress may be reduced or even eliminated. An abrupt change of such material properties at the mentioned interface may cause mechanical and/or thermal stress which may lead to undesired phenomena such as warpage, delamination, cracks, separation between different constituents. A stress reducing dielectric interface may at least reduce exerted stress. For example, the dielectric layer structure configured as a stress release layer may be a resin layer or a polymer layer.

In an embodiment, a depth of the dimple is in a range from 1 µm to 20 µm, in particular in a range from 3 µm to 10 µm. Although these depths of the dimple may be relatively small, filling them up with the dimple filling may significantly improve the accuracy of establishing a contact by the conductive element. Generally, controlling the depth with a specified accuracy during dimple filling may be accomplished for example by plating with a certain chemical composition (which may include one or additives), chemical flow in a bath, plating current control, rocking or shaking, etc.

In an embodiment, the hole has a ratio between a length and a minimum diameter of at least 2, in particular at least 5, more particularly at least 7. In particular in the presence of a hole with such a large aspect ratio, a sufficiently complete filling of such a hole with electrically conductive material may be conventionally challenging. However, exemplary embodiments of the invention may make use of the dimple generated by the hole filling and may combine it with a metal structure. This may reduce the efforts and costs of manufacturing and may meanwhile assure a highly reliable electric and/or thermic coupling. This may be achieved with a metal to metal (for example copper to copper) interconnection.

In an embodiment, the hole has an hourglass shape. Alternatively, the hole may have a continuously tapering shape.

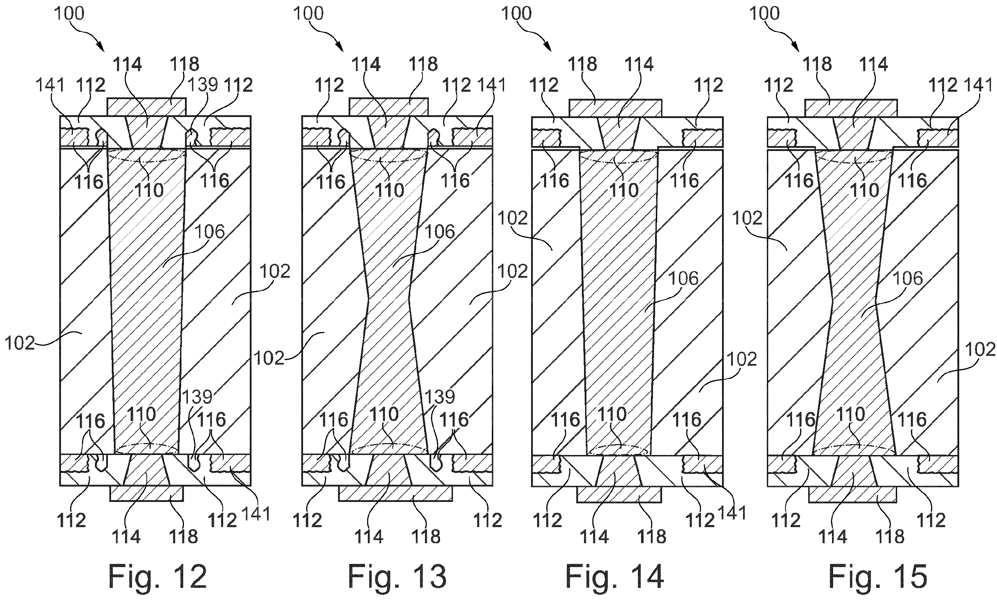

In this context, an hourglass shape may be formed by a through hole having two connected tapering sections with inverse tapering directions (compare Figure 12). Such an hourglass shape may be obtained by forming the respective hole by laser drilling from both opposing main surfaces of the carrier body.

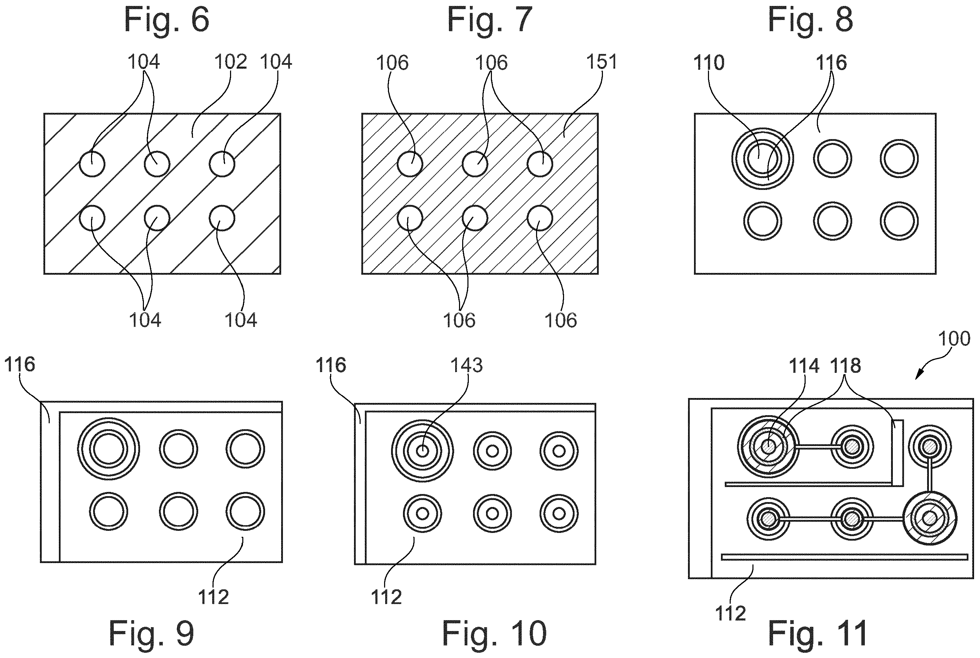

In alternative embodiments, the respective hole may have a frustoconical shape (compare Figure 11). Such a continuously tapering shape may be created by laser drilling from only one main surface of the carrier body. The hole may then taper towards the side of the carrier body facing away from the laser source.

In general, laser induced selective etching may be advantageous for through glass via (TGV) drilling. Hence, the glass structure may be modified by laser processing. Wet etching may be executed as well. Other possible methods are laser processing only, electrical discharge machining (EDM) with an assisted electrode, reactive ion etching, powder blast, mechanically drilling, spark assist chemical engraving, etc.

In an embodiment, the component carrier comprises a patterned metal layer directly on the carrier body. The patterned metal layer may be arranged between the metal structure and the dielectric layer structure and/or may be arranged between the carrier body and the dielectric layer structure. For example, the component carrier may comprise a patterned metal layer directly on the carrier body below the dielectric layer structure. Correspondingly, the method may comprise forming a patterned metal layer directly on the carrier body. Advantageously, such a patterned metal layer sandwiched between carrier body and dielectric layer structure may improve adhesion between the extremely smooth glass carrier body surface and the dielectric layer structure. This may significantly improve the mechanical reliability of the component carrier. Preferably, the dielectric layer structure may be formed partially on the patterned metal layer and partially on the carrier body in gaps between different sections of the patterned metal layer. This may improve engagement between dielectric layer structure and patterned metal layer and may also ensure a direct contact of the dielectric layer structure with the carrier body which may lead, in turn, to a strong impact of the buffering function of the dielectric layer structure on the carrier body.

In other embodiments, a patterned metal layer may not be needed and may be omitted, in particular since it may be not necessary to have an electrical connection for this layer.

In an embodiment, the patterned metal layer is configured as adhesion interface layer for promoting adhesion between the carrier body and the dielectric layer structure. For example, the patterned metal layer may be present for the purpose of promoting adhesion between this metal (for example copper) layer. The (for instance glass) carrier body and the dielectric layer structure as the patterned metal layer can provide anchoring points. This may also allow for a better handling for the (preferably glass) core in general, as the handling of inorganic material (such as glass) is always challenging.

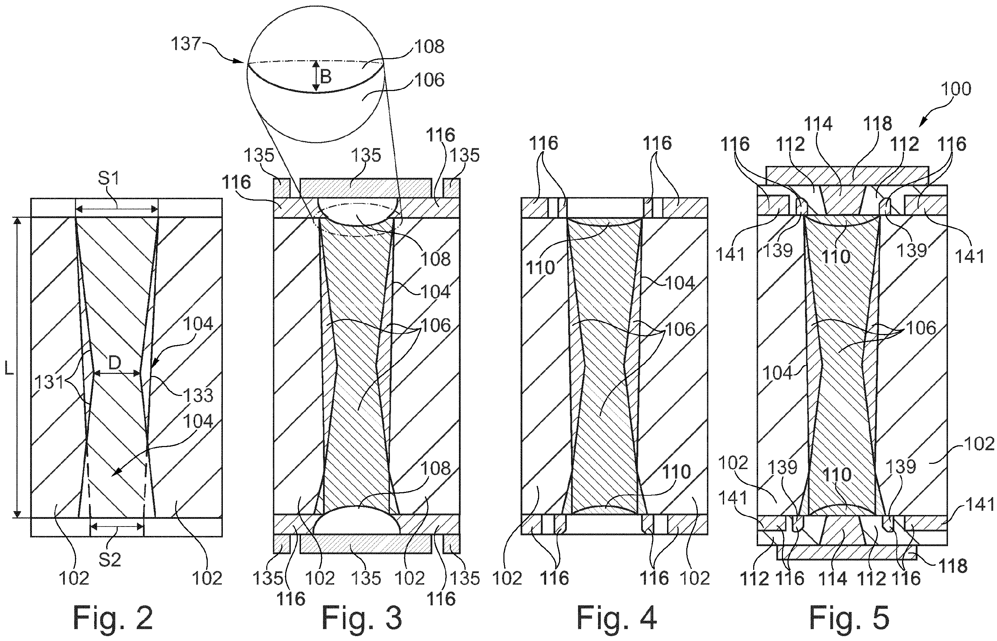

In an embodiment, the patterned metal layer comprises a laterally narrower section and a laterally broader section, the laterally narrower section being closer to the dimple than the laterally broader section (see for instance Figure 5). The laterally narrower section may also be closer to the axis of the metallized hole or via (depending on the shape of the vias) than the laterally broader section.

In an embodiment, the laterally narrower section is in direct physical contact with the dimple filling. Such a configuration has turned out to be particularly effective in terms of adhesion promotion. It is believed that in such a configuration, a particularly efficient anchoring effect enhances adhesion of the dielectric layer structure and the carrier body mediated by the patterned metal layer.

In an embodiment, the component carrier comprises a wiring structure for providing an electric wiring function, wherein the patterned metal layer is electrically decoupled from the wiring structure. Hence, the patterned metal layer may be electrically inactive, i.e. may be an electric dummy structure, and may function solely as adhesion promoting layer and for improving handling of the carrier body. It may provide the function of thermal dissipation as well. In contrast to this, the wiring structure may provide an electric function in terms of the functionality of the component carrier. For example, the wiring structure may be configured for transmitting electric signals and/or electric power. For instance, the wiring structure may comprise horizontal electric structures (such as traces, pads) and/or vertical electric structures (like vias, pillars), etc. In an embodiment, said wiring structure may have a line space ratio in a range from 2 µm/2 µm to 10 µm/10 µm, in particular 5 µm /5 µm. Hence, a fine line patterning with very small dimensions is possible above the carrier body. This is in particular possible when the carrier body is made of glass, thanks to the extreme smoothness of such a glass body.

In an embodiment, the component carrier comprises a wiring structure (which may be the wiring structure with the properties as described in the preceding paragraph) for providing an electric wiring function and being connected with the conductive element. For example, the electric wiring function may be to create an electrically conductive connection between an electronic component (which may be surface mounted on the component carrier) and a mounting base (on which the component carrier is to be mounted) via the at least one electrically conductive element, the dimple filling and the metal structure in the at least one hole.

In an embodiment, the component carrier comprises a wiring structure (which may be the wiring structure with the properties as described in the preceding paragraphs) for providing an electric wiring function, wherein the patterned metal layer has a higher roughness than the wiring structure. The higher roughness of the patterned metal layer as compared with the wiring structure may be the result of a roughening process selectively roughening the surface of the patterned metal layer for improving adhesion with the dielectric layer structure. In contrast to this, a smooth surface of the wiring structure may be desired for conducting electric signals and/or electric power with low loss. In particular for high-frequency signals, the skin effect may have the consequence that an electric high-frequency signal will only propagate in a thin skin or surface portion of the wiring structure. When such a surface portion is free of pronounced ripples thanks to a high smoothness, a high signal quality may be achieved.

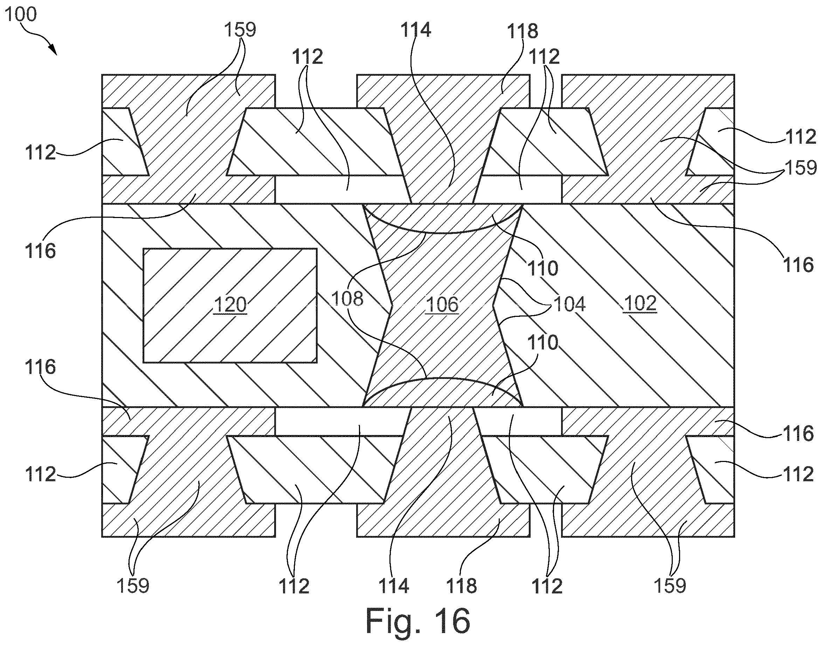

In an embodiment, the patterned metal layer is configured for shielding a component embedded in the carrier body (see for example Figure 16). The patterned metal layer can be functionalized as shielding for an embedded component (such as a capacitor, an inductor or a radiofrequency semiconductor chip) in the glass core or embedded elsewhere in the component carrier. For example in radiofrequency applications, embedded components (such as RF chips) may be sensitive with respect to electromagnetic radiation (in particular RF radiation) from the environment. At the same time, such embedded components may be electromagnetic radiation emitters emitting electromagnetic radiation which may disturb the function of other components or electronic members. By configuring the patterned metal layer to contribute to a shielding of electromagnetic radiation from propagating between an embedded component and an exterior of the component carrier, the electric reliability of the component carrier may be further improved. For example, the patterned metal layer may form or may form part of an electrically conductive cage around an embedded electronic component for shielding electromagnetic radiation. When the patterned metal layer is functionalized for shielding, it may be made for instance from a metal or a magnetic material.

In an embodiment, at least part of the patterned metal layer has a ring shape. In particular the above-mentioned narrower section may be annular or ring-shaped. The patterned metal layer may also have other shapes, for instance a hexagonal shape. If there is no ring structure, the design may be for example as in Figure 13 or Figure 14.

In an embodiment, the carrier body has a thickness in a range from 300 µm to 1000 µm, in particular in a range from 500 µm to 800 µm. A carrier body, in particular when made of glass, having such a high thickness may allow to provide a sufficient robustness and rigidity for efficiently suppressing warpage.

In an embodiment, the component carrier comprises an electronic component mounted on or above the carrier body and being electrically coupled with the at least one conductive element. One or more electronic components may be surface mounted. In the context of the present application, the term "electronic component" may particularly denote a member fulfilling an electronic task. Such an electronic component may be an active component such as a semiconductor chip comprising a semiconductor material, in particular as a primary or basic material. The electronic component may also be a passive component, for instance a capacitor or an inductor. Preferably, the electronic component comprises a semiconductor chip. The semiconductor chip may be made for instance based on a type IV semiconductor such as silicon or germanium, or may be a type III-V semiconductor material such as gallium arsenide. In particular, the semiconductor component may be a semiconductor chip such as a bare die or a molded die. A bare die may be a non-encapsulated (in particular non-molded) piece of semiconductor material (such as silicon) having at least one monolithically integrated circuit element (such as a diode or a transistor). Moreover, semiconductor materials suitable for photonic packages are also possible. For example, an electronic component to be surface mounted on the package may be an HBM (high-bandwidth memory) or a silicon interposer.

In an embodiment, the at least one conductive element has a frustoconical shape. Hence, the conductive element may taper towards the carrier body. When using a laser with subsequent plating to form the conductive element as metallic via (more precisely as metallic laser via), an obtained shape may correspond to that of a laser via. The laser via may have a shape in which the bottom is very small compared to the top.

In another embodiment, the at least one conductive element has a circular cylindrical shape. When using an excimer laser, the via taper can be much smaller, or even zero. When using an exposure, the structure can be straighter, for instance almost or exactly straight.

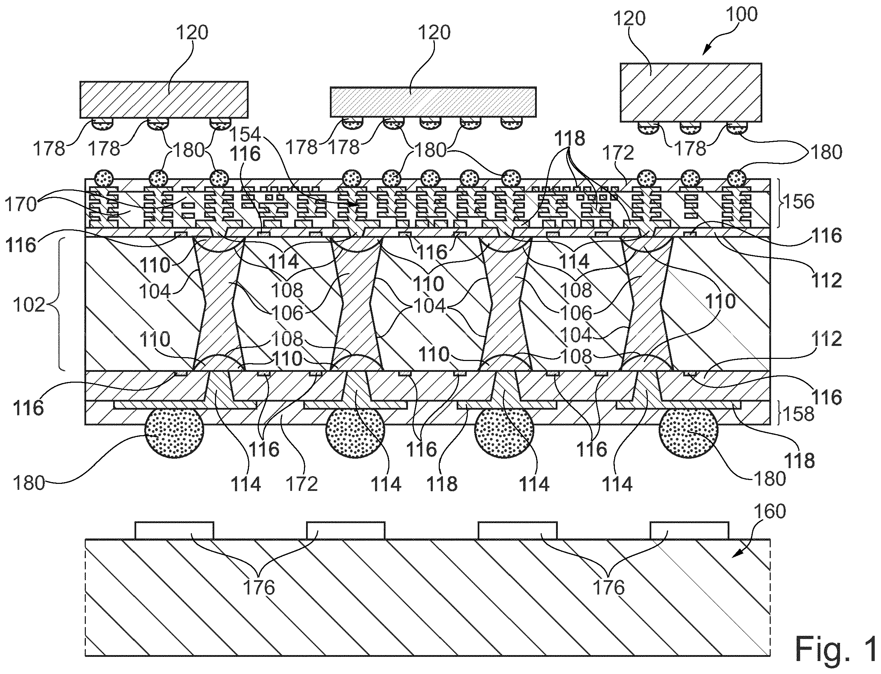

In an embodiment, the component carrier comprises a plurality of conductive elements arranged side by side (see for example Figure 1). Each of the conductive elements may be constructed as described above. Different conductive elements may be constructed correspondingly, for instance may all be constructed as metallic via extending up to, but not into, a respective dimple filling. The conductive elements arranged side-by-side may be manufactured by a common manufacturing process, and hence very efficiently. Multiple conductive elements extending up to the same (preferably glass) carrier body may allow to realize even complex electronic tasks by the component carrier.

In an embodiment, the method comprises forming the conductive element by laser drilling a recess up to the dimple filling, and by subsequently filling the laser drilled recess by a metallic material, in particular by plating. Such a plating process may involve, for example, electroless plating, sputtering, galvanic plating, etc.

In an embodiment, the method comprises roughening the patterned metal layer before forming the dielectric layer structure thereon. For instance, such a roughening process may be executed by etching, grinding or chemical treatment. A further roughened surface of the patterned metal layer may additionally enhance the adhesion of the dielectric layer structure on the exposed surface of the patterned metal layer. Figure 12 to Figure 15 show corresponding embodiments.

In an embodiment, the package comprises a mounting base, in particular a printed circuit board (PCB), on which the component carrier is mounted. Such a mounting base may connect the component carrier and its surface mounted component(s) mechanically and electrically with an electronic periphery.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or Interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene deri-vate (e.g. based on polyphenylenether, PPE), polyimide (PI), polyamide (PA), liquid crystal polymer (LCP), polytetrafluoroethylene (PTFE), Bisbenzocyclobu-tene (BCB) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 to Figure 5 illustrate cross-sectional views of structures obtained during carrying out a method of manufacturing a component carrier, shown in Figure 5, according to another exemplary embodiment of the invention.
Figure 6 to Figure 11 illustrate plan views of structures obtained during carrying out a method of manufacturing a component carrier, shown in Figure 11, according to another exemplary embodiment of the invention.
Figure 12 to Figure 15 illustrate cross-sectional views of component carriers according to different exemplary embodiments of the invention.
Figure 16 illustrates a cross-sectional view of a component carrier according to an exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

What concerns the formation of packages on glass, adhesion may be a challenge. For example, silane treatment on glass has been considered before polymer coating or lamination. Another conventional challenge is the formation of through glass vias (TGVs). In particular at a high aspect ratio of TGVs or bigger vias, metal filling may be conventionally difficult. Issues such as filling difficulties, remaining voids, thickness variation, overburden for underfill, delamination, crack may occur.

According to an embodiment of the invention, a component carrier for mounting at least one electronic component thereon and/or therein is formed based on a carrier body (preferably a glass carrier body) having one or more holes filled partially with a metal structure (for instance plated copper). An exterior dimple delimiting said metal structure is filled partially or entirely with an electrically conductive dimple filling (for example further copper material). A dielectric layer structure is applied on at least part of the carrier body and on part of the dimple filling. Such a dielectric layer structure may be formed directly on the carrier body for buffering stress. Moreover, a conductive element may be formed to extend through the dielectric layer structure and up to the dimple filling with direct physical contact. Consequently, the conductive element(s) may directly contact the dimple filling. In a simple way, this allows to establish a direct physical contact between conductive element and dimple filling. Hence, an improved reliability of an electric and/or thermal coupling in between may be achieved. Such a connection is reliable even when the filling of the hole with the metal structure is incomplete, for instance in the event of a high aspect ratio.

More specifically, exemplary embodiments of the invention may improve handling of a-- preferably glass-- carrier body and offer a streamline manufacturing process. Preferably, a patterned metal layer may be formed directly on the carrier body (such as further plated copper on glass) and may efficiently function as an adhesion promoter for the dielectric layer structure. It has been found that such an adhesion promoting effect can be achieved even in the event of extremely smooth glass surfaces with a roughness Ra of for example less than 50 nm. To create a reliable interconnection through a high aspect ratio TGV, a peripheral area of a dimpled TGV may be etched to isolate the interconnection of the TGV. Patterns of a copper layer may be formed on a polymer layer on glass. Then, the TGV may be interconnected to a top pad by a metallized laser via. A pattern on the glass may be formed after forming a TGV filling, in particular with an SAP (semi-additive processing) process.

Formation of a through glass via (TGV) or another hole in the glass carrier or in another carrier body may be accomplished, preferably by laser drilling and etching. Then, an electroless copper plating process may be executed for forming a metallic film on the surface. Subsequently, electrolytic copper plating may be carried out for completing formation of the metal structure. Thereafter, a dry film may be laminated on the obtained structure. A dry film opening may be created and then the patterned metal layer will be formed following with litho process, electrolytic copper plating and etching process. There can be an additional process to roughen the surface of the patterned metal layer for the adhesion promotion between the dielectric layer attached later and the glass. A dielectric layer may be attached, for instance by lamination of a resin sheet. It also can be photo imageable dielectric material. It may be possible to form the pattern including the via and trace at the same time by exposure or excimer laser, and then following with the electrolytic plating or other metal deposition process. The excimer laser can do it also on the normal dielectric material. A laser via may be formed extending through the dielectric layer. By a semi-additive process (SAP), the laser via may be filled with a metal, to thereby form a conductive element.

Descriptively speaking, the resin sheet may function as a stress release layer between glass material of the carrier body and a copper pattern above. Moreover, a copper structure may function as adhesion interface layer between the glass and the dielectric layer, such as a polymer.

In an embodiment, vias may be formed on a copper filled TGV and may be connected to a pattern on and/or in a polymer dielectric layer. Copper around and/or on the TGV may be etched to keep an isolation of the vias. A profiled copper surface may act as an adhesion promoter between the carrier, which may be embodied as glass core, and the dielectric layer. Advantageously, copper plated glass with a resin sheet in between can function as stress buffer on traces on and/or in the dielectric and may contribute to handle the glass panel easier as the resin sheet can help balance the CTE gap between the glass and the copper (in particular trace) and adjust the stress on trace. To put it shortly, plated copper may act as a mechanical buffer and as adhesion promoter layer, as it can provide anchoring points between the dielectric layer and glass. Additionally, it may provide the handling point for trace or patterned metal layer (such as copper) and glass, trace or patterned metal layer(copper) and resin. A proper interconnection between a high aspect ratio TGV and an adjacent layer may be made possible. In particular, a component carrier according to an exemplary embodiment of the invention may allow an easier panel handling. The risk of breakage of glass caused by the stress during processing can be reduced. Furthermore, the provision of a separate adhesion promoter (such as silane coupling agent that may be used to change the glass surface chemical structure) may be dispensable. Furthermore, the manufacturing architecture of exemplary embodiments of the invention is compatible with a glass substrate structure that has through glass vias with a high aspect ratio. Advantageously, a copper dummy layer may be provided that may improve glass protection, function as an adhesion layer, and may support a via shape interconnecting to the TGV.

Exemplary applications of exemplary embodiments of the invention relate to component carriers for mobile phones, servers, computing applications, in particular high performance computing (HPC), and related electronic devices.

Exemplary embodiments of the invention may allow to overcome conventional shortcomings concerning dielectric adhesion on a glass body. This may be accomplished by a patterned metal layer configured as adhesion interface layer for promoting adhesion between a glass carrier body and a dielectric layer structure.

Another conventional shortcoming is incomplete metal filling or the requirement of a long plating time when filling through glass vias with a large aspect ratio (i.e. ratio between length or thickness of the panel and minimum diameter) with metallic material. According to an exemplary embodiment, an efficient TGV metal filling process in particular in the event of a high aspect ratio (for instance at least 7 or at least 8) may be provided by a combination of a partial filling of the hole with plated metal, subsequently at least partially filling of a remaining dimple, and finally inserting conductive elements into the dimple filling. As a result, a glass carrier body with copper filled TGVs may be provided which can also be manufactured in a reliable way in the event of a high aspect ratio of for instance at least 7. Advantageously, this may be achieved by a patterned copper adhesion layer which may be arranged partially on the glass. A dielectric layer, for instance a resin layer, may function as stress release layer which may be arranged partially on the glass. Furthermore, copper vias on top may function as conductive elements for contacting the metallic TGV filling.

For example, electrically conductive elements (in particular metallic vias) may be formed in contact with a metallized hole (such as a metal filled through glass via) in a carrier body (preferably embodied as glass plate). The electrically conductive elements may be connected with a metallic pattern on a dielectric layer (such as a polymer layer). A metallic pattern (in particular copper) around a respective hole may be etched to keep the insulation of the respective via. Advantageously, a profiled metallic surface may act as adhesion promoter between the glass core and the dielectric layer. Furthermore, the dielectric layer coupled with the metal plated glass may function as stress buffer and may simplify handling of the glass panel.

To improve handling of the glass while streamlining the manufacturing process, the plated copper on glass may be used as adhesion promoter. In order to create an interconnection by a high aspect ratio TGV, a peripheral area of the template TGV may be etched to isolate the interconnection of the TGV. A pattern may be formed on a polymer layer formed, in turn, on the glass/copper layer. Then, the TGV may be interconnected to a top pad through a laser via.

**Figure 1** illustrates a cross-sectional view of a component carrier 100 according to an exemplary embodiment of the invention.

The illustrated component carrier 100 comprises a central carrier body 102 having a plurality of vertically extending through holes 104 extending through the entire carrier body 102. The carrier body 102 may be embodied as glass plate. The through holes 104 extending side-by-side vertically through the carrier body 102 may then be through glass vias (TGVs). They may be formed in the carrier body 102 by laser drilling from opposing main surfaces of the carrier body 102. As a result, the through holes 104 have an hourglass shape composed of two connected tapering sections with opposite tapering directions.

Again referring to Figure 1, each hole 104 is filled partially with a plated metal structure 106 delimited by an exterior dimple 108 on both sides. Each plated metal structure 106 has a concave surface next to each dimple 108. For example, the plated metal structure 106 may comprise solid copper formed by electroless plating or for instance by chemical vapor deposition or physical vapor deposition (for forming a thin seed layer) followed by electroplating (for creating thick bulk copper thereon). As illustrated, an electrically conductive dimple filling 110 (for example also made of copper) fills the respective dimple 108 and can be created for example by a further plating process. The dimple filling 110 may extend up to each of the opposing main surfaces of the carrier body 102. Hence, the respective dimple filling 110 extends up to the same vertical level as the carrier body 102, both at a bottom side and at a top side.

Moreover, a respective conductive element 114 may extend through a dielectric layer structure 112 formed on each main surface of the carrier body 102. Each dielectric layer structure 112, 112 may cover a surface portion of the carrier body 102 and part of the dimple fillings 110. Each conductive element 114 may for instance be a copper filled laser via. Each respective conductive element 114 may be brought in direct contact with the assigned dimple filling 110. For example, a flange face or front surface of a respective conductive element 114 may abut against an exterior horizontal surface of the respective dimple filling 110. Hence, it may be possible that the conductive element 114 does not extend into the dimple filling 110, which said conductive element 114 contacts. More specifically, two opposing conductive elements 114 may be provided per through hole 104, each extending with direct physical contact up to the assigned dimple filling 110. More specifically, each hole 104 has a dimple filling 110 as an upper end section connected by an upper conductive element 114 and has a further dimple filling 110 as an opposing lower end section connected by a lower conductive element 114. The tapering directions of the upper conductive element 114 and of the lower conductive element 114 may be inverse to each other, so that both may taper towards the carrier body 102. In the shown embodiment, the conductive elements 114 consist of solid copper and are thus both electrically conductive and thermally conductive. In the embodiment of Figure 1, each conductive element 114 has a frustoconical shape and is embodied as tapering metallic via which tapers towards the carrier body 102. Such a tapering via may be formed by laser drilling followed by copper plating.

As shown as well in Figure 1, upper dielectric layer structure 112 is arranged directly on an upper main surface of the carrier body 102. Dielectric layer structure 112 may for instance be a resin layer, a prepreg layer or a layer made of a photoimageable dielectric. As shown, all upper conductive elements 114 extend entirely through the upper dielectric layer structure 112 up to the respective electrically conductive dimple filling 110.

Correspondingly, lower dielectric layer structure 112 is arranged directly on a lower main surface of the carrier body 102. The lower dielectric layer structure 112 may be thicker than the upper dielectric layer structure 112. Lower dielectric layer structure 112 may for instance be a resin layer, a prepreg layer or a layer made of a photoimageable dielectric. As shown, all lower conductive elements 114 extend entirely through the lower dielectric layer structure 112 up to the respective electrically conductive dimple filling 110.

As shown, a redistribution structure 154 is formed as part of a build-up 156 on the upper dielectric layer structure 112 and above the upper main surface of the carrier body 102. No redistribution structure is formed as part of a further build-up 158 below the lower dielectric layer structure 112 and below the lower main surface of the carrier body 102. The top-sided dielectric layer structure 112 may form part of the redistribution structure 154.

Wiring structures 118 may be formed on and above the exposed surfaces of the respective dielectric layer structure 112, 112. As shown, at least some of the wiring structures 118 may form part of a laminated layer stack which additionally comprises one or more electrically insulating layer structures 170. The latter may comprise for example an organic laminate, a resin, optionally reinforcing particles such as glass fibers, etc. For instance, the electrically insulating layer structures 170 may be resin sheets, prepreg sheets, etc.

For instance, a metal layer may be formed (for instance by plating, in particular copper plating) or attached (for example as metal foil, in particular copper foil) on the respectively exterior side of the respective dielectric layer structure 112, 112. Thereafter, the metal layer may be patterned, for instance by a lithography and etching process to thereby obtain wiring structures 118 according to Figure 1. As already mentioned, the component carrier 100 comprises a plurality of conductive elements 114 arranged laterally side by side and vertically facing each other. Each of these conductive elements 114 may be coupled with a respective wiring structure 118.

Still referring to Figure 1, the dimensions of the wiring structure 118 on the exterior surface of the lower dielectric layer structure 112 may be coarser than on the exterior surface of the upper dielectric layer structure 112. In other words, the integration density, i.e. the number of electrically conductive elements of the wiring structure 118 per area or volume, may be larger above the upper dielectric layer structure 112 than below the lower dielectric layer structure 112.

As shown, the build-ups 156, 158 on the top side and on the bottom side of the carrier body 102 may be asymmetric (wherein a symmetric configuration may be possible in other embodiments, and a BGA (ball grid array) or an LGA (land grid array) configuration may be implemented). A reason for this asymmetry is that the top side is configured to comply with requirements of semiconductor chip technology, since electronic components 120 are to be mounted on the top side. On the other hand, the bottom side shall comply with requirements of PCB technology or the like, since the bottom side of the component carrier 100 may have to be mounted on a mounting base 160 such as a PCB. However, the pronounced rigidity of the glass carrier body 102 may lead to an acceptable degree of warpage despite of the asymmetry. By forming appropriately designed build-ups 156, 158, warpage may be further reduced.

A plurality of electronic components 120 are surface mounted on the build-up 156 above the carrier body 102 and are electrically coupled with the conductive elements 114 by the wiring structures 118. More generally, one or more electronic components 120 may be surface mounted on the component carrier 100. In particular, the illustrated electronic component(s) 120 may be a semiconductor chip, for example for RF (radio frequency) applications.

Electrically conductive pads 178 of the electronic components 120 may be electrically connected with the wiring structures 118 of build-up 156 by solder structures 180, such as solder balls, or another interconnection structure (such as a sinter material, metal to metal bonding (for example copper to copper), hybrid bonding, wiring bonding).

Also surface finish 172 (like ENIG or ENEPIG, a solder resist, etc.) may be optionally applied on the top side of build-up 156 and/or on the bottom side of the build-up 158. The exterior electrically insulating layer structures are formed as a surface finish 172 embodied as solder resist. The solder resist may support correct soldering of component carrier 100 on electrically conductive pads 176 of mounting base 160 below (for example a printed circuit board) by solder structures 180, such as solder balls. Correspondingly, the solder resist may support correct soldering of electronic components 120 on build-up 156 by solder structures 180.

Advantageously, the respective dielectric layer structure 112 is configured as a stress release layer, i.e. may be configured for releasing stress between the material above and below. In particular by adjusting material properties, such as the value of the coefficient of thermal expansion (CTE) and/or the value of the Young modulus, of the respective stress release layer interface stress may be reduced or even eliminated. Such a stress may result from different material properties above and below the stress release layer. An abrupt change of such material properties may cause mechanical and/or thermal stress which may lead to undesired phenomena such as warpage, delamination, cracks, etc. Thus, the dielectric layer structures 112 functioning also for releasing stress may improve the reliability of the component carrier 100.

However, direct adhesion of the dielectric layer structures 112 on the extremely smooth glass surface (for instance having a roughness Ra of not more than 50 nm) of the carrier body 102 may be a challenge. In order to improve adhesion between the respective dielectric layer structure 112 and the carrier body 102 made of glass, a patterned metal layer 116 may be formed directly on the carrier body 102 between the carrier body 102 and the dielectric layer structure 112. For example, the patterned metal layer 116 may be provided for the sole purpose of improving adhesion of the respective dielectric layer structure 112 but may be itself electrically inactive. Hence, the patterned metal layer 116 may also be electrically decoupled from the wiring structures 118.

Figure 2 to Figure 5 illustrate cross-sectional views of structures obtained during carrying out a method of manufacturing a component carrier 100, shown in Figure 5, according to another exemplary embodiment of the invention.

Referring to **Figure 2****,** a cross-sectional view of a carrier body 102 embodied as glass plate is shown.

A through hole 104 is formed to extend vertically through the carrier body 102. More precisely, two types of through holes 104 are indicated in Figure 2: A first embodiment of such a through hole 104 is a through hole having hourglass shape, see reference sign 131. A through hole 104 with hourglass shape may be formed as a through hole 104 having two connected tapering sections with inverse tapering directions. Such an hourglass shape may be obtained by forming the respective hole 104 by laser drilling from both opposing main surfaces of the carrier body 102. A second embodiment of such a through hole 104 is a through hole having continuously tapering shape, see reference sign 133. The latter mentioned type of through hole 104 may have a frustoconical shape. Such a continuously tapering shape may be created by laser drilling from only one main surface of the carrier body 102. The hole 104 may then taper towards the side of the carrier body 102 facing away from the laser source (not shown).

Now referring to the embodiment in which the hole 104 has an hourglass shape, a minimum diameter D in a central portion thereof may be for example 50 µm. A length L of through hole 104 may correspond to a thickness of the carrier body 102. This thickness may be preferably in a range from 500 µm to 750 µm, or even up to 1000 µm, for example 800 µm. Thus, a thick glass plate may be used as carrier body 102. When a carrier body 100 made of glass and having a thickness of 100 µm is used, the minimum diameter D may also be smaller, for instance 20 µm or less.

Now referring to the embodiment in which the hole 104 has a continuously tapering shape, a maximum diameter S1 may for example be 100 µm, whereas a minimum diameter S2 may be for example 50 µm (for example at a thickness of the carrier body 102 of 800 µm). Hence, in both embodiments, the through hole 104 has a significantly high aspect ratio, i.e. ratio between length L and a minimum diameter D or S2 of for example more than 7.

Since carrier body 102 is made of glass, it may have an extremely smooth surface, for instance having a roughness of not more than 100 nm. This is on the one hand advantageous, since it allows fine line patterning thereon and closely above. On the other hand, this is a challenge, since adhesion on such a smooth surface may be an issue.

Referring to **Figure 3****,** the carrier body 102 with its through hole 104 is shown in a cross-sectional view in which the through hole 104 is filled partially with a plated metal structure 106 delimited by an exterior dimple 108 on both ends. Hence, a plating process may be carried out for partially filling the through hole 104 with plated metal structure 106. For instance, such a plating process may comprise electroless plating for forming a thin seed layer of copper on the walls of the carrier body 102 delimiting the through hole 104. Moreover, the plating process may subsequently comprise one or more electroplating stages (such as one or more galvanic plating stages) for depositing bulk copper on the seed layer. Due to the high aspect ratio of the through hole 104, a respective void volume, i.e. an upper and a lower dimple 108, may remain above and below the plated metal structure 106. On the upper side and on the lower side, the plated metal structure 106 is delimited by a concave surface. As shown in a detail 137 in Figure 3, a depth B of the dimple 108 may be for example in a range from 3 µm to 10 µm. Said depth may be controlled by correspondingly adjusting the plating process or the shape of the through glass via. The laser via depth and the via plating crosses may have an impact on the depth.

Furthermore, a metal layer 116 may be formed directly on the carrier body 102 during the above mentioned plating process, or by a separate metal deposition process. Preferably, metal layer 116 may be formed after filling through hole 104 by plated metal structure 106. Metal layer 116 may be also made of copper. Furthermore, a mask 135 is applied on each respective metal layer 116 for preparing a patterning process. For instance, mask 135 may be a patterned dry film laminate.

Referring to **Figure 4****,** portions of the respective metal layer 116 being exposed with respect to mask 135 (which may be a polymerized dry film) may be removed, for instance by etching or another material removal process. Mask 135 may be removed (see Figure 4). As a result, a patterned metal layer 116 is obtained on each main surface of the carrier body 102. Advantageously, the patterned metal layer 116 is configured as adhesion interface layer for promoting adhesion between the carrier body 102 and a respective dielectric layer structure 112 formed thereon subsequently. Optionally, it may be possible to roughen the patterned metal layer 116 before forming the dielectric layer structure 112 thereon, for further enhancing adhesion.

As shown as well in Figure 4, the dimple 108 - both on the top side and on the bottom side of Figure 3 - may be filled by an electrically conductive dimple filling 110, for instance also copper. For example, dimple filling 110 may be created by a further plating process or by another metal deposition process (for instance printing or dispensing). It is also possible that the dimple filling 110 is formed with the metal layer 116 at the same plating process. The dimple filling 110 may completely fill the through hole 104, for instance may be in flush with the upper and lower main surfaces of the carrier body 102.

Referring to **Figure 5****,** a respective dielectric layer structure 112 is formed partially on the respective patterned metal layer 116, partially on the carrier body 102 and partially on the dimple filling 110. For instance, each dielectric layer structure 112 may be a resin layer or a prepreg layer. As already mentioned above, adhesion of the respective dielectric layer structure 112 may be significantly improved by the respective patterned metal layer 116 as compared with a scenario in which the dielectric layer structure 112 is formed directly on the very smooth surface of the glass-type carrier body 102. Hence, sandwiching the respective patterned metal layer 116 in between may significantly improve the mechanical integrity of the component carrier 100 being manufactured.

Thereafter, the obtained structure may be subjected to laser drilling. More specifically, a laser hole is formed extending through the entire respective dielectric layer structure 112 up to the metallic dimple filling 110 (which may function for example as a laser stop layer).

After having formed the respective laser hole in each dielectric layer structure 112, the laser hole may be filled with electrically conductive material by plating to thereby form a respective conductive element 114. As shown, each conductive element 114 extends through the respective dielectric layer structure 112 so as to be in contact with the dimple filling 110. This ensures a reliable electrical and thermal coupling of the respective conductive element 114 with the dimple filling 110.

Thereafter, further metallic material may be deposited or may be attached as a metal foil to the exposed surfaces of the respective conductive element 114 and the assigned dielectric layer structure 112. Said further metallic material may be patterned for forming wiring structures 118. The wiring structures 118 may be electrically coupled with the conductive elements 114, for the transmission of electric signals and/or electric power. However, at least part of the adhesion promoting patterned metal layer 116 may be electrically decoupled from the conductive elements 114 and the wiring structures 118. Thus, at least part of the adhesion promoting patterned metal layers 116 may be electrically inactive and may be provided for the specific purpose of improving adhesion for the subsequently formed dielectric layer structures 112.

As a result of the described manufacturing process, the illustrated component carrier 100 is provided which has the glass-type carrier body 102 with its through hole 104 filled at least partially with the plated metal structure 106. The electrically conductive dimple filling 110 fills the dimples 108 at the exterior ends of the plated metal structure 106. A respective dielectric layer structure 112 is formed as stress release structure on each of the two opposing main surfaces of the carrier body 102, on part of the dimple filling 110 and on the patterned metal layer 116, in particular on the corner of the dimple filling 110. Conductive elements 114 extend through both dielectric layer structures 112 for establishing a direct physical contact with the dimple filling 110 on both sides of the carrier body 102.

Advantageously, each of the patterned metal layers 116 comprises a laterally narrower section 139 and a laterally broader section 141, the laterally narrower section 139 being closer to the dimple 108 than the laterally broader section 141. It has been found that this configuration of the patterned metal layers 116 provides highly beneficial properties in terms of adhesion promotion for the dielectric layer structures 112. Furthermore, the laterally narrower section 139 may be in direct physical contact with the dimple filling 110. Patterned metal layer 116 may provide a kind of interlocking constitution. A high resin rich area surrounding a via can be made small or even minimized. The TGV may be isolated by another entity, it does not matter whether the patterned metal layer 116 is connected to the TGV or not. As already mentioned above, the wiring structure 118 for providing an electric wiring function on the one hand and at least the laterally broader section 141 of the patterned metal layer 116 on the other hand are electrically decoupled from each other. Hence, the laterally broader section 141 of the patterned metal layer 116 may be, from an electrical point of view, an unconnected dummy structure functioning solely for promoting adhesion. Also for this reason, the patterned metal layer 116 may have a higher roughness than the wiring structure 118.

Figure 6 to Figure 11 illustrate plan views of structures obtained during carrying out a method of manufacturing a component carrier 100, shown in Figure 11, according to another exemplary embodiment of the invention.

Referring to **Figure 6****,** a plan view of the structure corresponding to Figure 2 is shown.

Referring to **Figure 7****,** a plan view of the structure of Figure 6 is shown after having formed a seed layer 151, for instance by electroless deposition. The seed layer 151 may be made of a metal, such as copper.

Referring to **Figure 8****,** a plan view of the structure of Figure 7 is shown after galvanic plating and patterning. Consequently, patterned metal layer 116 and dimple filling 110 may be formed. As shown, the patterned metal layer 116 comprises a ring structure around a metallized hole 104. To put it shortly, Figure 8 shows the structure after pattern plating.

Referring to **Figure 9****,** a plan view of the structure of Figure 8 is shown after forming dielectric layer structure 112 on the patterned metal layer 116, on the dimple filling 110 and on the glass carrier body 102. This may be done by laminating a resin layer on top of the structure of Figure 8.

Referring to **Figure 10****,** a plan view of the structure of Figure 9 is shown after laser drilling for forming a through hole 143 in the dielectric layer structure 112 for subsequent formation of conductive element 114.

Referring to **Figure 11****,** a plan view of the structure of Figure 10 is shown after formation and structuring of further metallic structures. More specifically, said further metallic structures may encompass conductive element 114 in through hole 143 and wiring structure 118 connected with conductive element 114 and forming traces on the surface of the component carrier 100 shown in Figure 11.

Figure 12 to Figure 15 illustrate cross-sectional views of component carriers 100 according to different exemplary embodiments of the invention.

Referring to **Figure 12****,** a component carrier 100 with the properties according to Figure 5 is shown, wherein the through hole 104 has a continuously tapering shape. The surface of the patterned metal layers 116 has been roughened (for instance by grinding, by etching or by chemical treatment) for promoting adhesion of dielectric layer structure 112.

The component carrier 100 according to **Figure 13** differs from the component carrier 100 according to Figure 12 in that, according to Figure 13, the through hole 104 has an hourglass type, rather than being continuously tapering as in Figure 12.

The component carrier 100 according to **Figure 14** differs from the component carrier 100 according to Figure 12 in that, according to Figure 14, the laterally narrower section 139 of the patterned metal layer 116 is omitted.

The component carrier 100 according to **Figure 15** differs from the component carrier 100 according to Figure 13 in that, according to Figure 15, the laterally narrower section 139 of the patterned metal layer 116 is omitted.

**Figure 16** illustrates a cross-sectional view of a component carrier 100 according to an exemplary embodiment of the invention.

In the embodiment of Figure 16, the patterned metal layers 116 are configured for shielding a component 120 embedded in the carrier body 102. For example, component 120 may be a high-frequency component which needs shielding against electromagnetic radiation from an environmental. The patterned metal layers 116 may form, together with further metallic or magnetic structures 159, a shielding cage for shielding the component 120 from electromagnetic radiation.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

## Claims

1. A component carrier (100), which comprises:
a carrier body (102) having a hole (104) filled partially with a metal structure (106) delimited by an exterior dimple (108);
an electrically conductive dimple filling (110) at least partially filling the dimple (108); **characterised by**
a dielectric layer structure (112) on at least part of the carrier body (102) and on part of the dimple filling (110); and
a conductive element (114) extending through the dielectric layer structure (112) and being in contact with the dimple filling (110).

2. The component carrier (100) according to claim 1, wherein the dielectric layer structure (112) is configured as a stress release layer.

3. The component carrier (100) according to claim 1 or 2, wherein a depth (B) of the dimple (108) is in a range from 1 µm to 20 µm, in particular in a range from 3 µm to 10 µm.

4. The component carrier (100) according to any of claims 1 to 3, wherein the hole (104) has a ratio between a length (L) and a minimum diameter (D) of at least 2, in particular at least 5, more particularly at least 7.

5. The component carrier (100) according to any of claims 1 to 4, wherein the hole (104) has an hourglass shape or a continuously tapering shape.

6. The component carrier (100) according to any of claims 1 to 5, comprising a patterned metal layer (116) directly on the carrier body (102), in particular between the metal structure (106) and the dielectric layer structure (112) and/or between the carrier body (102) and the dielectric layer structure (112). AD:jc

7. The component carrier (100) according to claim 6, wherein the patterned metal layer (116) is configured as adhesion interface layer for promoting adhesion between the carrier body (102) and the dielectric layer structure (112).

8. The component carrier (100) according to claim 6 or 7, wherein the patterned metal layer (116) comprises a laterally narrower section (139) and a laterally broader section (141), the laterally narrower section (139) being closer to the dimple (108) than the laterally broader section (141), wherein in particular the laterally narrower section (139) is in direct physical contact with the dimple filling (110).

9. The component carrier (100) according to any of claims 6 to 8, comprising a wiring structure (118) for providing an electric wiring function, wherein the patterned metal layer (116) is electrically decoupled from the wiring structure (118).

10. The component carrier (100) according to any of claims 6 to 9, wherein the patterned metal layer (116) is configured for shielding a component (120) embedded in the carrier body (102).

11. The component carrier (100) according to any of claims 6 to 10, wherein at least part of the patterned metal layer (116) has a ring shape.

12. The component carrier (100) according to any of claims 6 to 11, comprising a wiring structure (118) for providing an electric wiring function, wherein the patterned metal layer (116) has a higher roughness than the wiring structure (118).

13. A method of manufacturing a component carrier (100), wherein the method comprises:
providing a carrier body (102) having a hole (104) filled partially with a metal structure (106) delimited by an exterior dimple (108);
at least partially filling the dimple (108) by an electrically conductive dimple filling (110); charactzerised by
forming a dielectric layer structure (112) on at least part of the carrier body (102) and on part of the dimple filling (110); and
forming a conductive element (114) extending through the dielectric layer structure (112) and being in contact with the dimple filling (110).

14. The method according to claim 13, wherein the method comprises forming a patterned metal layer (116) directly on the carrier body (102).

15. The method according to claim 14, wherein the method comprises roughening the patterned metal layer (116) before forming the dielectric layer structure (112) thereon.

## Patentansprüche

1. Komponententräger (100), umfassend:
einen Trägerkörper (102) mit einem Loch (104), das teilweise mit einer Metallstruktur (106) gefüllt ist, die durch eine äußere Vertiefung (108) begrenzt ist;
eine elektrisch leitfähige Vertiefungsfüllung (110), die die Vertiefung (108) mindestens teilweise füllt; **gekennzeichnet durch**
eine dielektrische Schichtstruktur (112) auf mindestens einem Teil des Trägerkörpers (102) und auf einem Teil der Vertiefungsfüllung (110); und
ein leitendes Element (114), das sich durch die dielektrische Schichtstruktur (112) erstreckt und in Kontakt mit der Vertiefungsfüllung (110) ist.

2. Komponententräger (100) nach Anspruch 1, wobei die dielektrische Schichtstruktur (112) als eine Entspannungsschicht ausgelegt ist.

3. Komponententräger (100) nach Anspruch 1 oder 2, wobei eine Tiefe (B) der Vertiefung (108) in einem Bereich von 1 µm bis 20 µm, insbesondere in einem Bereich von 3 µm bis 10 µm liegt.

4. Komponententräger (100) nach einem der Ansprüche 1 bis 3, wobei das Loch (104) ein Verhältnis zwischen einer Länge (L) und einem Mindestdurchmesser (D) von mindestens 2, insbesondere mindestens 5, insbesondere mindestens 7 aufweist.

5. Komponententräger (100) nach einem der Ansprüche 1 bis 4, wobei das Loch (104) eine Sanduhrform oder eine sich kontinuierlich verjüngende Form aufweist.

6. Komponententräger (100) nach einem der Ansprüche 1 bis 5, umfassend eine strukturierte Metallschicht (116) direkt auf dem Trägerkörper (102), insbesondere zwischen der Metallstruktur (106) und der dielektrischen Schichtstruktur (112) und/oder zwischen dem Trägerkörper (102) und der dielektrischen Schichtstruktur (112).

7. Komponententräger (100) nach Anspruch 6, wobei die strukturierte Metallschicht (116) als Haftzwischenschicht zur Förderung der Haftung zwischen dem Trägerkörper (102) und der dielektrischen Schichtstruktur (112) ausgelegt ist.

8. Komponententräger (100) nach Anspruch 6 oder 7, wobei die strukturierte Metallschicht (116) einen seitlich schmaleren Abschnitt (139) und einen seitlich breiteren Abschnitt (141) aufweist, wobei der seitlich schmalere Abschnitt (139) näher an der Vertiefung (108) liegt als der seitlich breitere Abschnitt (141), wobei insbesondere der seitlich schmalere Abschnitt (139) in direktem physikalischen Kontakt mit der Vertiefungsfüllung (110) steht.

9. Komponententräger (100) nach einem der Ansprüche 6 bis 8, umfassend eine Verdrahtungsstruktur (118) zum Bereitstellen einer elektrischen Verdrahtungsfunktion, wobei die strukturierte Metallschicht (116) elektrisch von der Verdrahtungsstruktur (118) entkoppelt ist.

10. Komponententräger (100) nach einem der Ansprüche 6 bis 9, wobei die strukturierte Metallschicht (116) zum Abschirmen einer in den Trägerkörper (102) eingebetteten Komponente (120) ausgelegt ist.

11. Komponententräger (100) nach einem der Ansprüche 6 bis 10, wobei mindestens ein Teil der strukturierten Metallschicht (116) eine Ringform aufweist.

12. Komponententräger (100) nach einem der Ansprüche 6 bis 11, umfassend eine Verdrahtungsstruktur (118) zum Bereitstellen einer elektrischen Verdrahtungsfunktion, wobei die strukturierte Metallschicht (116) eine höhere Rauheit als die Verdrahtungsstruktur (118) aufweist.

13. Verfahren zum Herstellen eines Komponententrägers (100), wobei das Verfahren umfasst:
Bereitstellen eines Trägerkörpers (102) mit einem Loch (104), das teilweise mit einer Metallstruktur (106) gefüllt ist, die durch eine äußere Vertiefung (108) begrenzt ist;
mindestens teilweises Füllen der Vertiefung (108) durch eine elektrisch leitfähige Vertiefungsfüllung (110); **gekennzeichnet durch**
Ausbilden einer dielektrischen Schichtstruktur (112) auf mindestens einem Teil des Trägerkörpers (102) und auf einem Teil der Vertiefungsfüllung (110); und
Ausbilden eines leitenden Elements (114), das sich durch die dielektrische Schichtstruktur (112) erstreckt und in Kontakt mit der Vertiefungsfüllung (110) ist.

14. Verfahren nach Anspruch 13, wobei das Verfahren ein Ausbilden einer gemusterten Metallschicht (116) direkt auf dem Trägerkörper (102) umfasst.

15. Verfahren nach Anspruch 14, wobei das Verfahren ein Aufrauen der strukturierten Metallschicht (116) vor dem Ausbilden der dielektrischen Schichtstruktur (112) darauf umfasst.

## Revendications

1. Support de composant (100), qui comprend :
un corps de support (102) ayant un trou (104) rempli partiellement d'une structure métallique (106) délimitée par une alvéole extérieure (108) ;
un remplissage d'alvéole électroconducteur (110) remplissant au moins partiellement l'alvéole (108) ; **caractérisé par**
une structure de couche diélectrique (112) sur au moins une partie du corps de support (102) et sur une partie du remplissage d'alvéole (110) ; et
un élément conducteur (114) s'étendant à travers la structure de couche diélectrique (112) et étant en contact avec le remplissage d'alvéole (110).

2. Support de composant (100) selon la revendication 1, dans lequel la structure de couche diélectrique (112) est configurée comme une couche de libération de contrainte.

3. Support de composant (100) selon la revendication 1 ou 2, dans lequel une profondeur (B) de l'alvéole (108) est dans une plage de 1 µm à 20 µm, en particulier dans une plage de 3 µm à 10 µm.

4. Support de composant (100) selon l'une des revendications 1 à 3, dans lequel le trou (104) présente un rapport entre une longueur (L) et un diamètre minimal (D) d'au moins 2, en particulier d'au moins 5, plus particulièrement d'au moins 7.

5. Support de composant (100) selon l'une quelconque des revendications 1 à 4, dans lequel le trou (104) a une forme de sablier ou une forme se rétrécissant de manière continue.

6. Support de composant (100) selon l'une quelconque des revendications 1 à 5, comprenant une couche métallique à motif (116) directement sur le corps de support (102), en particulier entre la structure métallique (106) et la structure de couche diélectrique (112) et/ou entre le corps de support (102) et la structure de couche diélectrique (112).

7. Support de composant (100) selon la revendication 6, dans lequel la couche métallique à motif (116) est configurée comme couche d'interface d'adhérence destinée à favoriser l'adhérence entre le corps de support (102) et la structure de couche diélectrique (112).

8. Support de composant (100) selon la revendication 6 ou 7, dans lequel la couche métallique à motif (116) comprend une section latéralement plus étroite (139) et une section latéralement plus large (141), la section latéralement plus étroite (139) étant plus proche de l'alvéole (108) que la section latéralement plus large (141), la section latéralement plus étroite (139) étant en contact physique direct avec le remplissage d'alvéole (110).

9. Support de composants (100) selon l'une quelconque des revendications 6 à 8, comprenant une structure de câblage (118) pour fournir une fonction de câblage électrique, dans lequel la couche métallique à motif (116) est électriquement découplée de la structure de câblage (118).

10. Support de composant (100) selon l'une quelconque des revendications 6 à 9, dans lequel la couche métallique à motif (116) est configurée pour blinder un composant (120) noyé dans le corps de support (102).

11. Support de composant (100) selon l'une quelconque des revendications 6 à 10, dans lequel au moins une partie de la couche métallique à motif (116) présente une forme annulaire.

12. Support de composants (100) selon l'une quelconque des revendications 6 à 11, comprenant une structure de câblage (118) pour fournir une fonction de câblage électrique, dans lequel la couche métallique à motif (116) présente une rugosité supérieure à celle de la structure de câblage (118).

13. Procédé de fabrication d'un support de composant (100), dans lequel le procédé comprend :
la fourniture d'un corps de support (102) ayant un trou (104) rempli partiellement d'une structure métallique (106) délimitée par une alvéole extérieure (108) ;
le remplissage au moins partiel de l'alvéole (108) par un remplissage d'alvéole électroconducteur (110) ; **caractérisé par**
la formation d'une structure de couche diélectrique (112) sur au moins une partie du corps de support (102) et sur une partie du remplissage d'alvéole (110) ; et
la formation d'un élément conducteur (114) s'étendant à travers la structure de couche diélectrique (112) et étant en contact avec le remplissage d'alvéole (110).

14. Procédé selon la revendication 13, dans lequel le procédé comprend la formation d'une couche métallique à motif (116) directement sur le corps de support (102).

15. Procédé selon la revendication 14, dans lequel le procédé comprend la rugosification de la couche métallique à motif (116) avant la formation de la structure de couche diélectrique (112) sur celle-ci.
